# EUROPÄISCHE PATENTSCHRIFT

(11) **EP 0 590 508 B1**
(45) Veröffentlichungstag und Bekanntmachung des Hinweises auf die Patenterteilung: **10.07.2002**
(21) Anmeldenummer: 93115307.6
(22) Anmeldetag: 23.09.1993
(51) Int. Cl.: H01L 21/322

(54) **Entfernung von Verunreinigungen und Verbesserung der Minoritätsladungsträger-Lebensdauer bei Silicium**
Removal of impurities and improvement of minority carriers life-time in silicon
Extraction d'impuretés et amélioration de la durée de vie des porteurs minoritaires dans de silicium

(30) Priorität: 26.09.1992 IT RM920687; 03.11.1992 US 971056
(43) Veröffentlichungstag der Anmeldung: 06.04.1994
(73) Patentinhaber: MEMC Electronic Materials, Inc., St. Peters, Missouri 63376 (US)
(72) Erfinder: Falster, Robert, I-28100 Novara (IT)
(74) Vertreter: Maiwald, Walter, Dr. Dipl.-Chem.

(56) Entgegenhaltungen:
- US-A- 4 410 395
- MATERIALS SCIENCE AND ENGINEERING B, Bd. B7, Nr. 1 / 02, 1.September 1990, Seiten 49-62, XP000149277 VERHOEF L A ET AL: "GETTERING IN POLYCRYSTALLINE SILICON SOLAR CELLS"
- APPLIED PHYSICS LETTERS, 21 OCT. 1991, USA, Bd. 59, Nr. 17, ISSN 0003-6951, Seiten 2133-2135, XP002036226 GAO X ET AL: "Annealing and profile of interstitial iron in boron-doped silicon"
- PROCEEDINGS OF THE INTERNATIONAL CONFERENCE ON THE SCIENCE AND TECHNOLOGY OF DEFECTS IN SEMICONDUCTORS, 17. - 22.September 1989, YOKOHAMA, JP, NORTH HOLLAND PUBLISHING COMPANY, NL;, Seiten 323-328, XP002036227 D. GILLES ET AL: "Internal gettering of iron in czochralski silicon: Model and quantitative analysis"

## Beschreibung

### HINTERGRUND DER ERFINDUNG

Die vorliegende Erfindung bezieht sich auf Silicium und Silicium-Wafer, die bei der Herstellung von Halbleiter Bauelementen verwendet werden, und auf das Verfahren zur Verbesserung der Minoritätsladungsträger-Rekombinationslebensdauer bei Silicium mittels Verringerung der Eisenverunreinigung.

Die Minoritätsladungsträger-Rekombinationslebensdauer und die Minoritätsladungsträger-Diffusionslänge eines Siliciumkörpers sind ähnlich und werden daher bisweilen untereinander austauschbar erwähnt. Beim p-Typ Silicium wird die Beziehung zwischen der Minoritätsladungsträger-Diffusionslänge und der Minoritätsladungsträger-Rekombinationslebensdauer in der folgenden Formel ausgedrückt: L_{d} = ((Dₙ) (tₙ))^{0,5}, wobei L_{d} die Minoritätsladungsträger-Diffusionslänge in Zentimetern, Dₙ der Elektronendiffusionskoeffizient, der mit 35 cm²/s anzunehmen ist, und tₙ die Minoritätsladungsträger-Rekombinationslebensdauer in Sekunden ist. Beim n-Typ Silicium wird die Beziehung zwischen der Minoritätsladungsträger-Diffusionslänge und die Minoritätsladungsträger-Rekombinationslebensdauer in der folgenden Formel ausgedrückt: L_{*d*} = ((Dₚ) (tₚ))^{0,5}, wobei L_{d} die Minoritätsladungsträger-Diffusionslänge in Zentimetern, Dₚ der Lochdiffusionskoeffizient, der mit 12,5 cm²/s anzunehmen ist, und tₚ die Minoritätsladungsträger-Rekombinationslebensdauer in Sekunden ist.

Verschiedene Verfahren können zur Messung der Minoritätsladungsträger-Rekombinationslebensdauer (oder der Minoritätsladungsträger-Diffusionslänge) eines Silicium-Wafers angewendet werden und schließen in der Regel die Injektion von Ladungsträgern in eine Wafer-Probe mittels eines Lichtblitzes oder durch Spannungsimpulse und die Beobachtung ihres Abfalls ein. Ein Verfahren für die Messung der Minoritätsladungsträger-Rekombinationslebensdauer ist das von Zoth und Bergholz, J. Appl. Phys., 67, 6764 (1990), beschriebene Oberflächen-Photospannungsverfahren (SPV).

Oder sonst kann die Diffusionslänge unter Verwendung eines von GeMeTec (München, Deutschland) hergestellten ELYMAT-Instruments gemessen werden, das mit einer Auflösung von ca. 1 mm die von einem Scanning-Laserstrahl erzeugten und von einer verdünnten elektrolytischen HF-Funktion gesammelten Photoströme mißt. Die Minoritätsladungsträger-Diffusionslängen werden von diesen Daten berechnet, und es lassen sich Diffusionslängenbilder anfertigen. Siehe z. B. H. Foell et al., Proc. ESSDERC Conference, Berlin 1989, S. 44. Die berechneten Diffusionslängenwerte können mit Hilfe der obigen Formeln leicht in Minoritätsladungsträger-Rekombinationslebensdauerwerte umgewandelt werden.

Mit der Weiterentwicklung der integrierten Stromkreistechnologie und der zunehmenden Verkleinerung der elektrischen Bauelemente erhöht sich weiterhin die Notwendigkeit, für Metallvereinreinigungen verschärftere Grenzen festzusetzen. Metallverunreinigungen bei Silicium, wie z. B. bei einem Silicium-Wafer, verursachen eine Verringerung der Minoritätsladungsträger-Rekombinationslebensdauer und führen zu störenden elektrischen Kriechströmen in den Silicium enthaltenden elektrischen Bauelementen. Störende elektrische Kriechstromwege treten an metallisch verunreinigten Punktfehlstellen in der Nähe von elektrischen Verbindungen innerhalb der Zellstruktur der Bauelemente oder Teilbaulelemente oder über Kriechstromwege in die als Feldeffekttore von Isolierstrukturen benutzten Oxide auf. Beide Kriechstromwege werden nachteilig vergrößert, wenn das Silicium mit Metallen wie Eisen, Kupfer, Nickel, Chrom und Titan verunreinigt ist.

Getterverfahren wurden zur Reduzierung oder Eliminierung von Metallverunreinigungen in Silicium-Wafern angewendet. Diese Verfahren schließen die Einführung von Störstellen in Silicium-Wafern an Orten ein, die nicht die Funktionstüchtigkeit der im Wafer hergestellten elektronischen Bauelemente beeinträchtigen. Störstellen wurden beispielsweise in die Rückseite des Wafers (externes Gettern) und durch das Niederschlagen von Sauerstoff im Innern des Wafers, jedoch nicht in der Nähe der Oberfläche (internes Gettern), eingeführt.

Obwohl die Getterverfahren nützlich gewesen sind, um schnell diffundierende Metalle wie Kupfer und Nickel daran zu hindern, sich aktiv an Rekombinationsprozessen in denjenigen Bereichen zu beteiligen, die elektronische Bauelemente enthalten, waren diese Verfahren nicht besonders effektiv für Metalle wie Eisen, Chrom und Titan, die im Vergleich zu Kupfer und Nickel relativ langsam diffundieren. Darüber hinaus können die ins Silicium als Gettering-Stellen eingeführten Defekte selbst die Silicium-Qualität beispielsweise durch die Verringerung der Minoritätsladungsträger-Rekombinationslebensdauer reduzieren. In der Praxis hatte daher die Industrie bislang kaum eine andere Wahl, als die Quellen der Eisen-, Chrom- und Titan-, insbesondere Eisenverunreinigungen in dem möglichen Maße zu identifizieren und zu eliminieren. Eine solche Methode wird jedoch immer kostspieliger, da es erforderlich ist, immer niedrigere Eisenverunreinigungsgrade zu erzielen; die Herstellung von Silicium-Wafern und Bauelementen mit Siliciumkomponenten schließt viele Schritte und potentielle Verunreinigungsquellen ein, die jeweils sorgfältig zu prüfen und zu überwachen sind.

### ZUSAMMENFASSUNG DER ERFINDUNG

Unter den verschiedenen Gegenständen der Erfindung können angeführt werden: die Bereitstellung eines Verfahrens zur Verbesserung der Silicium-Qualität; die Bereitstellung eines Verfahrens für die Reduzierung der Eisenkonzentration im Innern der Siliciumkörper im allgemeinen und der Silicium-Wafer im besonderen; die Bereitstellung eines solchen Verfahrens, das nicht die Kosten übermäßig erhöht oder das Silicium-Waferstellungsverfahren ungebührlich kompliziert; die Bereitstellung eines solchen Verfahrens, das keine Defekte in die Silicium-Wafer einführt; und die Bereitstellung eines solchen Verfahrens, das zu einer signifikanten Erhöhung der Minoritätsladungsträger-Rekombinationslebensdauer von Silicium-Wafern führt.

Kurz ausgedrückt - ist daher die vorliegende Erfindung auf ein Verfahren gerichtet, das die Minoritätsladungsträger-Rekominbinationslebensdauer in einem Siliciumkörper erhöht, der mit einem aus der aus Eisen, Chrom, Kobalt, Mangan, Zink und Vanadium bestehenden Gruppe ausgewählten Metall verunreinigt ist. Der Siliciumkörper wird bei einer ausreichenden Temperatur und für eine ausreichende Dauer gelagert, um die Diffusion einer ausreichenden Menge Eisen aus dem Innern des Siliciumkörpers an die Oberfläche des Siliciumkörpers zu bewirken und die Minoritätsladungsträger-Rekombinationslebensdauer des Siliciumkörpers meßbar zu erhöhen. Die Lagerzeit beträgt mindestens 48 Stunden.

### KURZE BESCHREIBUNG DER ZEICHNUNGEN

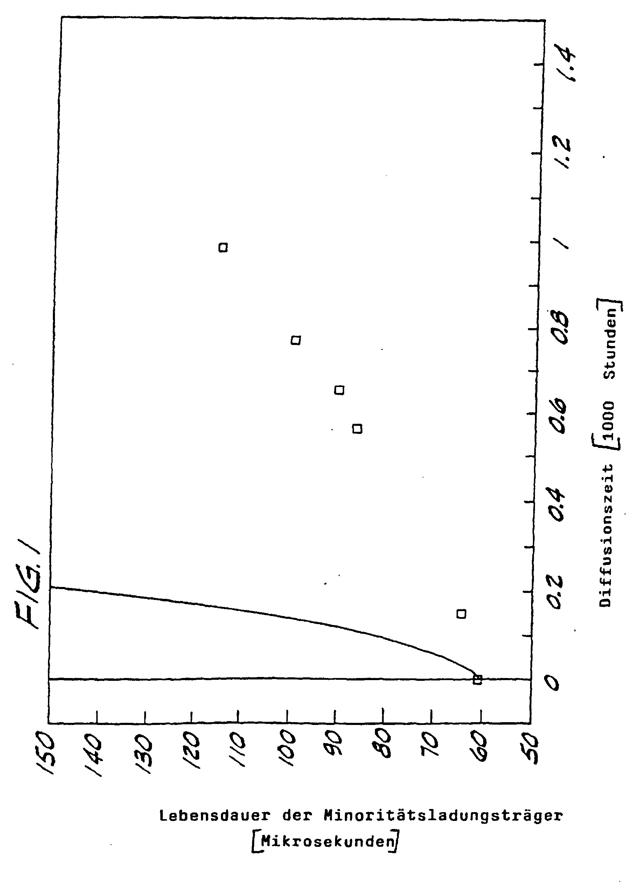

Abb. 1 ist eine graphische Darstellung von Daten für CZ-Silicium-Wafer mit einer Dicke von 625 µm und einem Durchmesser von 150 mm, die für unterschiedliche Zeitlängen entsprechend der vorliegenden Erfindung bei 280 °C gelagert werden. Auf der vertikalen Achse werden die Minoritätsladungsträger-Rekombinationslebensdauerwerte der Wafer in Mikrosekunden und auf der horizontalen Achse die Lagerzeiten in Stunden angegeben.

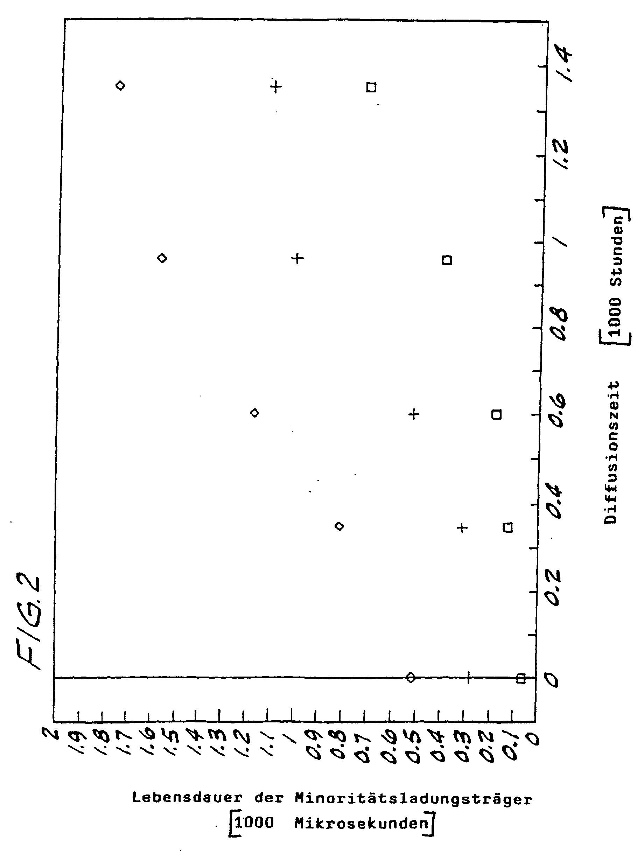

Abb. 2 ist eine graphische Darstellung von Daten für MCZ-Silicium-Wafer mit einer Dicke von 1 400 µm und einem Durchmesser von 150 mm, die für unterschiedliche Zeitlängen entsprechend der vorliegenden Erfindung bei 400 °C gelagert werden. Auf der vertikalen Achse werden die Minoritätsladungsträger-Rekombinationslebensdauerwerte der Wafer in Mikrosekunden und auf der horizontalen Achse die Lagerzeiten in Stunden angegeben.

### DETAILLIERTE BESCHREIBUNG DER ERFINDUNG

Die hier im Zusammenhang mit einem Siliciumkörper, wie z. B. einem Silicium-Wafer, benutzten Begriffe Minoritätsladungsträger-Rekombinationslebensdauer und Minoritätsladungsträger-Diffusionslänge gelten als durchschnittliche Minoritätsladungsträger-Rekombinationslebensdauer und durchschnittliche Minoritätsladungsträger-Diffusionslänge für den gesamten Körper.

Es wurde entdeckt, daß die Minoritätsladungsträger-Rekombinationslebensdauer von Silicium-Wafern durch die Verringerung der durchschnittlichen Eisenkonzentration mittels Anwendung des Verfahrens der vorliegenden Erfindung erhöht werden kann. Silicium-Wafer, die aus einem nach den herkömmlichen Czochralski ("CZ")-Kristallziehverfahren gezüchteten Silicium-einkristall geschnitten und nach herkömmlichen Wafer-Formverfahren hergestellt werden, haben eine durchschnittliche Minoritätsladungsträger-Rekombinationslebensdauer von weniger als ca. 200 Mikrosekunden und einen durchschnittlichen Eisengehalt im Bereich von ca. 10¹⁰ bis 10¹¹ Atomen/cm³. Anhand des Verfahrens der vorliegenden Erfindung können Eisenkonzentrationen von weniger als 10¹⁰ Atomen/cm³ und vorzugsweise weniger als 5 x 10⁹ Atomen/cm³ bei einer entsprechenden meßbaren Erhöhung der Minoritätsladungsträger-Rekombinationslebensdauer erzielt werden.

Das Verfahren der vorliegenden Erfindung kann zur Erhöhung der Minoritätsladungsträger-Rekombinationslebensdauer eines Siliciumkörpers eingesetzt werden - dies ungeachtet der Art und Weise, wie dieser Körper hergestellt wurde und unabhängig von der Lebensdauer des Körpers vor der Bearbeitung in dieser Weise, sofern die Lebensdauer mindestens teilweise durch die Eisenverunreinigung begrenzt ist. Die Minoritätsladungsträger-Rekombinationslebensdauer kann durch meßbare Größen, wie z. B. 100, 200 oder mehrere hundert Mikrosekunden und darüber, erhöht werden, was zu einer 25%-, 50%-, 100%igen oder größeren Verbesserung der Minoritätsladungsträger-Rekombinationslebensdauer führt. Dementsprechend kann die Minoritätsladungsträger-Rekombinationslebensdauer von Wafern mit einer Lebensdauer von ca. 200 Mikrosekunden auf mehrere hundert Mikrosekunden, mindestens etwa 500 Mikrosekunden oder sogar eine Millisekunde oder länger erhöht werden.

Nach diesem Verfahren wird ein Siliciumkörper, wie z. B. ein Silicium-Wafer, für eine längere Zeitdauer bei einer erhöhten Temperatur gelagert. Die Wahl einer höheren Temperatur und Lagerdauer für einen bestimmten Siliciumkörper macht die Abwägung mehrerer Überlegungen erforderlich. Da sich das Diffusionsvermögens von Eisen bei zunehmender Temperatur erhöht, sollte eine Lagertemperatur gewählt werden, bei welcher der Diffusionskoeffizient von Eisen ausreichend groß ist, um es erheblichen Eisenmengen zu ermöglichen, vom Inneren an die Oberfläche des Wafers in einer kommerziell praktischen Lagerzeit zu diffundieren. Dementsprechend beträgt die Lagertemperatur etwa mindestens 200 °C, vorzugsweise etwa mindestens 225 °C, besser etwa mindestens 250 °C, noch besser etwa mindestens 300 °C und am besten etwa mindestens 350 °C.

Die Löslichkeit von Eisen in Silicium erhöht sich jedoch ebenfalls mit zunehmender Temperatur. Spezifische Löslichkeitswerte gibt es nicht unbedingt, doch einige allgemein anerkannte Daten wurden von Weber, Appl. Phys. A30, 1 (1983) vorgelegt. Es ist wünschenswert, die Lagertemperatur ausreichend niedrig zu halten, um die in der festen Lösung unter Gleichgewichtsbedingungen lösliche Eisenmenge zu reduzieren. Im allgemeinen ist es daher besser, wenn die Lagertemperatur etwa 550 °C, vorzugsweise etwa 500 °C und noch besser etwa 390 °C und am besten etwa 350 °C nicht überschreitet.

Die jeweils gewählte Lagertemperatur wird auch vom Sauerstoffgehalt und von der Herstellungsart des Siliciums beeinflußt. Einkristall-Silicium, das nach den herkömmlichen Czochralski ("CZ")-Verfahren oder nach dem CZ-Verfahren in Anwesenheit eines Magnetfeldes mit Cusp-Anordnung hergestellt wird, hat in der Regel einen Sauerstoffgehalt zwischen etwa 14 und 20 Teilen je Million Atome ("ppma") gemäß ASTM Standard F121-83. Bezeichnenderweise werden in Silicium, das mehr als etwa 10 ppma Sauerstoff enthält, unerwünschte Arten von sauerstoffbedingten Störstellen, die manchmal als "thermische Donatoren" bezeichnet werden, im Temperaturbereich zwischen etwa 400 °C und 500 °C gebildet. So werden Wafer mit einem Sauerstoffgehalt von mehr als etwa 10 ppma vorzugsweise bei einer Temperatur von weniger als etwa 400 °C, besser bei einer Temperatur von weniger als 390 °, noch besser bei einer Temperatur von weniger als 380 °C und am besten bei einer Temperatur von etwa 350 °C gelagert. Im Gegensatz zum herkömmlichen CZ-Silicium wird Einkristall-Silicium, das nach dem Zonenschmelzverfahren gezogen wird, durch Änderungen des CZ-Verfahrens in Anwesenheit eines axialen oder transversalen Magnetfeldes oder durch andere zu entwickelnde Verfahren einen Sauerstoffgehalt unter 10 ppma haben. Dieses niedrigsauerstoffhaltige Silicium kann Lagertemperaturen zwischen etwa 400 °C und 500 °C ohne wesentliches Risiko der Erzeugung sauerstoffbedingter Störstellen tolerieren.

Die Länge der Lagerzeit sollte für die Diffusion bedeutender Eisenmengen aus dem Inneren des Siliciums an seine Oberfläche ausreichend sein. Falls der Siliciumkörper beispielsweise ein Wafer ist, geht es um das Wafer-Innere, da Verbesserungen der Minoritätsladungsträger-Rekombinationslebensdauer mittels Reduzierung der Eisenkonzentration nicht nur an der Oberfläche des Siliciums erreicht werden, sondern mittels Reduzierung der Eisenkonzentration tief im Inneren und sogar überall im gesamten Silicium-Wafer. Es geht auch um das Wafer-Innere, da das Eisen - sofern nicht der Eisengehalt innerhalb des Wafers in wesentlich unter seiner Oberfläche liegenden Bereichen reduziert wird - in Bereichen des Wafers bleiben könnte, wo es - wenn es bei späteren Bauelemente-Herstellungsschritten höheren Temperaturen ausgesetzt wird - zum Bauelementebereich des Wafers diffundieren kann.

Zur Verbesserung der Minoritätsladungsträger-Rekombinationslebensdauer in einem Silicium-Wafer und zur Herabsetzung des Risikos der Diffusion von Eisen aus den zentralen Bereichen des Wafers in kritische Bereiche bei späteren Arbeitsgängen wird daher die Diffusion von Eisen aus Bereichen des Wafer-Inneren in Abständen von der Waferoberfläche, die größer als 10 % der Waferdicke sind, zur Waferoberfläche bewirkt. Zur Verbesserung der Minoritätsladungsträger-Rekombinationslebensdauer in einem Silicium-Wafer mit einer Dicke von mindestens 100 µm wird beispielsweise die Diffusion von Eisen aus Bereichen des Wafer-Inneren in Abständen von mehr als 10 µm von der Vorder- und Rückseite des Wafers zur Oberfläche bewirkt. Vorzugsweise wird die Diffusion von Eisen aus Bereichen des Wafer-Inneren in Abständen von der Waferoberfläche, die größer als 20 % der Waferdicke sind, besser aus Bereichen mit Abständen von der Waferoberfläche von mehr als 30 % der Waferdicke und am besten von der gesamten Dicke des Wafers zur Oberfläche bewirkt. Die für die Erreichung einer solchen Diffusion erforderliche Lagerdauer hängt von zahlreichen Faktoren ab, einschließlich der Waferdicke, der Lagertemperatur und der aus dem Wafer zu entfernenden Eisenmenge. Im allgemeinen wurde festgestellt, daß Lagerzeiten von mindestens 2 Tagen, vorzugsweise mindestens 4 Tagen, besser mindestens 7 Tagen und am besten mindestens 10 Tagen ausreichend sind.

Es ist optimal, wenn die Lagerzeit in die Folge der herkömmlichen Silicium-Verarbeitungsgänge einbezogen wird, die den Fachleuten bekannt sind. Beschreibungen dieser Arbeitsgänge sind beispielsweise bei F. Shimura. Semiconductor Silicon Crystal Technology, Academic Press, 1989, und Silicon Chemical Etching,(J. Grabmaier Hrsg.) Springer-Verlag, New York, 1982 enthalten (und werden mittels Bezugnahme hierin einbezogen) und können das Kristallziehen, das Schneiden von Wafern in Scheiben, die Formgebung, die Donator-Wärmebehandlung, das Ätzen und das Polieren einschließen. Es ist besser, wenn diese Lagerzeit vor dem Endpolieren, jedoch nach den Arbeitsgängen (wie z. *B.* der Donator-Wärmebehandlung), bei denen ein bedeutendes Potential für weitere Eisenverunreinigungen besteht, erfolgt. Angesichts der Position dieser Lagerzeit innerhalb der Wafer-Herstellungsfolge und angesichts ihrer Wirksamkeit bei der Reduzierung von Metallverunreinigungen ist die Notwendigkeit für die Eliminierung von Verunreinigungsquellen bei den vor der Lagerzeit liegenden Arbeitsgängen erheblich reduziert. Viele Komplikationen und Kosten für die Arbeitsgänge zur Herstellung und Handhabung von Reinstsilicium-Wafern können daher vermieden werden. Des weiteren kann die Einführung von Metallverunreinigungen in Wafer in einem bedeutend höherem Maße als ohne dieses Verfahren toleriert werden (obwohl sie vorzugsweise immer noch vermieden wird), da diese Verunreinigungen später entfernt werden können, wie dies nachstehend beschrieben wird.

Nach Beendigung der Lagerzeit kann das vom Inneren des Wafers an die Wafer-Oberfläche diffundierte Eisen mittels Verfahren entfernt werden, welche das Reinigen, Polieren, Ätzen oder Kombinationen derselben einschließen können. Diese Arbeitsgänge sind im Stand der Technik gut bekannt und werden beispielsweise bei F. Shimura, Semiconductor Silicon Crystal Technology, Academic Press (Kapitel 5.5), 1989 beschrieben (und mittels Bezugnahme hierin einbezogen). Das Reinigen kann anhand der weitverbreiteten RCA-Reinigungsbehandlungsmethode erfolgen, die beispielsweise in Kapitel 5.5 und Anlage XII bei Shimura im einzelnen beschrieben wird. Das Polieren erfolgt gewöhnlich durch chemomechanische Prozesse, bei denen die zu polierende Oberfläche mit einem saugfähigen Pad in Kontakt gebracht wird, auf den eine Schmirgelpulveremulsion fließt. Ätzlösungen sind im Stand der Technik ebenfalls gut bekannt, einschließlich derjenigen, die Kombinationen von Fluorwasserstoff-, Salpeter- und Essigsäure enthalten. Die Oberflächenschicht, die das diffundierte Eisen enthält, das durch ein oder mehrere dieser Methoden zu entfernen ist, hat im allgemeinen eine Dicke von wenigen Mikrometern oder darunter.

Die folgenden Beispiele veranschaulichen des weiteren die Wirkungsweise der Erfindung.

### BEISPIEL 1

Ein Silicium-Wafer wurde aus einem mittels des Czochralski-Kristallziehverfahrens hergestellten Einkristall-Siliciumblock geschnitten. Die Dicke und der Durchmesser des Wafers betrugen 825 Mikrometer bzw. 150 Millimeter. Die durchschnittliche Minoritätsladungsträger-Rekombinationslebensdauer des Wafers wurde durch ELYMAT-Messung mit etwa 61 Mikrosekunden bestimmt. Der durchschnittliche Eisengehalt des Wafers wurde auf 2,9 x 10¹¹ cm⁻³ geschätzt. Der Wafer wurde dann in ein Quarzschiffchen gegeben und in einen Ofen vom Typ Gallenkamp 300 plus bei einer Temperatur von 280 °C 980 Stunden lang an der Luft gelagert. Der Wafer wurde abgekühlt und durch ELYMAT-Messung eine durchschnittliche Minoritätsladungsträger-Rekombinationslebensdauer von ca. 115 Mikrosekunden ermittelt. Der durchschnittliche Eisengehalt wurde auf etwa 1,6 x 10¹¹ cm⁻³ bestimmt. Die Minoritätsladungsträger-Rekombinationslebensdauern von 61 und 115 Mikrosekunden vor bzw. nach der Lagerung sind in Abb. 1 dargestellt. In Abb. 1 sind ebenfalls die Minoritätsladungsträger-Rekombinationslebensdauerwerte für ähnliche Wafer graphisch dargestellt, die für Perioden zwischen 0 und 980 Stunden gelagert wurden. Die in Abb. 1 dargestellte durchgezogene Linie ist die geschätzte Erhöhung der Minoritätsladungsträger-Rekombinationslebensdauer, die über die Zeit für einen ähnlichen bei 350 °C gelagerten Wafer erwartet wird.

### BEISPIEL 2

Ein Silicium-Wafer wurde aus einem mittels des Czochralski-Kristallziehverfahrens hergestellten Einkristall-Siliciumblock geschnitten. Die Dicke und der Durchmesser des Wafers betrugen 1 400 Mikrometer bzw. 150 Millimeter. Die durchschnittliche Minoritätsladungsträger-Rekombinationslebensdauer des Wafers wurde durch ELYMAT-Messung mit etwa 65 Mikrosekunden bestimmt. Der durchschnittliche Eisengehalt des Wafers wurde auf 2,8 x 10¹¹ cm⁻³ geschätzt. Die Wafer wurde dann in ein Quarzschiffchen gegeben und in einem Quarzrohrofen bei einer Temperatur von 400 °C 1 350 Stunden lang unter N₂ gelagert. Der Wafer wurde abgekühlt und durch ELYMAT-Messung eine durchschnittliche Minoritätsladungsträger-Rekombinationslebensdauer von ca. 717 Mikrosekunden ermittelt. Der durchschnittliche Eisengehalt wurde auf etwa 2,5 x 10¹⁰ cm⁻³ bestimmt. Die Minoritätsladungsträger-Rekombinationslebensdauern von 65 und 717 Mikrosekunden vor bzw. nach der Lagerung sind in Abb. 2 dargestellt. In Abb. 2 sind ebenfalls die Minoritätsladungsträger-Rekombinationslebensdauerwerte für ähnliche Wafer graphisch dargestellt, die für Perioden zwischen 0 und 1 350 Stunden gelagert wurden.

### BEISPIEL 3

Ein Silicium-Wafer wurde aus einem mittels des Czochralski-Kristallziehverfahrens hergestellten Einkristall-Siliciumblock in Anwesenheit eines transversalen Magnetfeldes geschnitten. Die Dicke und der Durchmesser des Wafers betrugen 1 400 Mikrometer bzw. 150 Millimeter. Die durchschnittliche Minoritätsladungsträger-Rekombinationslebensdauer des Wafers wurde durch ELYMAT-Messung mit etwa 280 Mikrosekunden bestimmt. Der durchschnittliche Eisengehalt des Wafers wurde auf 4,6 x 10¹⁰ cm⁻³ geschätzt. Der Wafer wurde dann in ein Quarzschiffchen gegeben und in einem Quarzrohrofen bei einer Temperatur von 400 °C 1 350 Stunden lang unter N₂ gelagert. Der Wafer wurde abgekühlt und durch ELYMAT-Messung eine durchschnittliche Minoritätsladungsträger-Rekombinationslebensdauer von ca. 1 111 Mikrosekunden ermittelt. Der durchschnittliche Eisengehalt wurde auf etwa 1,6 x 10¹⁰ cm⁻³ bestimmt. Die Minoritätsladungsträger-Rekombinationslebensdauern von 280 und 1 111 Mikrosekunden vor bzw. nach der Lagerung sind in Abb. 2 dargestellt. In Abb. 2 sind ebenfalls die Minoritätsladungsträger-Rekombinationslebensdauerwerte für ähnliche Wafer graphisch dargestellt, die für Perioden zwischen 0 und 1 350 Stunden gelagert wurden.

### BEISPIEL 4

Ein Silicium-Wafer wurde aus einem mittels des Czochralski-Kristallziehverfahrens hergestellten Einkristall-Siliciumblock in Anwesenheit eines transversalen Magnetfeldes geschnitten. Die Dicke und der Durchmesser des Wafers betrugen 1 400 Mikrometer bzw. 150 Millimeter. Die durchschnittliche Minoritätsladungsträger-Rekombinationslebensdauer des Wafers wurde durch ELYMAT-Messung mit etwa 515 Mikrosekunden bestimmt. Der durchschnittliche Eisengehalt des Wafers wurde auf 3,5 x 10¹⁰ cm⁻³ geschätzt.

Der Wafer wurde dann in ein Quarzschiffchen gegeben und in einem Quarzrohrofen bei einer Temperatur von 400 °C 1 350 Stunden lang unter N₂ gelagert. Der Wafer wurde abgekühlt und durch ELYMAT-Messung eine durchschnittliche Minoritätsladungsträger-Rekombinationslebensdauer von ca. 1 770 Mikrosekunden ermittelt. Der durchschnittliche Eisengehalt wurde auf etwa 1 x 10¹⁰ cm⁻³ bestimmt. Die Minoritätsladungsträger-Rekombinationslebensdauern von 515 und 1 770 Mikrosekunden vor bzw. nach der Lagerung sind in Abb. 2 dargestellt. In Abb. 2 sind ebenfalls die Minoritätsladungsträger-Rekombinationslebensdauerwerte für ähnliche Wafer graphisch dargestellt, die für Perioden zwischen 0 und 1 350 Stunden gelagert wurden.

Dieses Verfahren wurde in Verbindung mit Einkristall-Silicium-Wafern beschrieben, die das Ausgangsmaterial für die Herstellung elektronischer Bauelemente sind. Es ist jedoch anzunehmen, daß dieses Verfahren ebenfalls für die Begrenzung von Verunreinigungen in polykristallinen Siliciumkörpern, in fertigen oder fast fertigen elektronischen Bauelementen auf Silicium-Basis selbst und in siliciumhaltigen Halbleiter-Bauelementen anwendbar ist. Insbesondere läßt sich durch die Anwendung der obengenannten Lagerungszeiten und Temperaturen eine Reduzierung der Verunreinigungen im Inneren und eine Verbesserung der Minoritätsladungsträger-Rekombinationslebensdauer sowie eine Verbesserung der Minoritätsladungsträger-Diffusionslänge und der Minoritätsladungsträger-Rekombinationslebensdauer im Silicium-Substrat, aus dem elektronische Bauelemente hergestellt werden, erzielen. In bestimmten Bauelementen kann die Oberfläche, zu der die Diffusion des Eisens bewirkt wird, eher eine Grenzschicht innerhalb des Bauelementes als eine Oberfläche an der Außenseite des Bauelementes sein. Eine solche Verarbeitung kann in bestimmten Fällen zu einer signifikanten Leistungsverbesserung des Bauelementes führen.

Ein bestimmtes elektronisches Bauelement, das von der Verarbeitung nach der vorliegenden Erfindung profitieren könnte, sind photovoltaische oder Solarzellen. Da die Minoritätsladungsträger-Diffusionslänge des Siliciums in solchen Bauelementen ein Hauptfaktor für die Beeinflussung der Effizienz ist, könnten sie durch ein derartiges Verfahren erheblich verbessert werden. Auf einer bestimmten Stufe etwa am Ende der Herstellungsfolge einer photovoltaischen Zelle, vorzugsweise nach der letzten Wärmebehandlung über 550 °C, würde die Zelle bei einer Temperatur und für eine Dauer wie oben beschrieben gelagert werden.
Solche Temperaturen ließen sich vorteilhaft durch eine passive Solarerwärmung erreichen, wodurch die Kosten für eine solche Lagerung relativ niedrig gehalten werden. Es würde dadurch die Diffusion von Eisen aus Bereichen des Wafer-Inneren in Abständen von der Waferoberfläche, die größer als 10 % der Waferdicke sind, vorzugsweise von Bereichen in Abständen von der Waferoberfläche, die 30 % größer als die Waferdicke sind, und am besten von der gesamten Dicke des Wafers bewirkt werden. Nach der Behandlung wäre jedoch kein Ätzen oder Polieren der Oberflächen, zu denen das Eisen diffundiert ist, möglich. Das Eisen würde an der Oberfläche des Siliciums oder an einer Grenzschicht zwischen dem Silicium und einer Oberflächenschicht bleiben, wo es die Minoritätsladungsträger-Diffusionslänge des Silicium-Inneren nicht erheblich reduzieren würde. Des weiteren würde nicht erwartet werden, daß erhebliche Mengen des diffundierten Eisens in Bereiche im Silicium zurückdiffundieren, in denen es sich für die Minoritätsladungsträger-Diffusionslänge nachteilig auswirken würde, da die Zelle danach nicht genügend hohen Temperaturen ausgesetzt werden würde, um eine solche Diffusion zu bewirken.

Es sollte auch darauf verwiesen werden, daß die vorliegende Erfindung eine Erhöhung der Minoritätsladungsträger-Rekombinationslebensdauer durch die Begrenzung anderer Übergangsmetallverunreinigungen als Eisen einschließt. Auf die Eisenverunreinigung wird in der vorstehenden Beschreibung aufgrund ihrer allgegenwärtigen Natur bei der Siliciumverarbeitung und ihres Übergewichts bei den Nachteilen für die Minoritätsladungsträger-Rekombinationslebensdauer das Hauptaugenmerk gelenkt. Nach dem Stand der Technik ist es möglich, andere Siliciumverunreingungen zu begrenzen, die bekannte physikalische Eigenschaften haben, die sie unter ähnlichen Bedingungen wie Eisen diffundieren lassen, wobei sich diese Bedingungen auf das Silicium oder das Bauelement nicht nachteilig auswirken. Diese Übergangsmetall-Verunreinigungen schließen Chrom, Kobalt, Mangan, Zink und Vanadium ein.

Wenn auch spezifische Beispiele für die vorliegende Erfindung und ihre Anwendung angegeben wurden, sind sie für die Erfindung nicht erschöpfend oder einschränkend. Diese Veranschaulichungen und Erklärungen sollen andere Fachleute mit der Erfindung, ihren Prinzipien und ihrer praktischen Anwendung vertraut machen, so daß sie die Erfindung in ihren zahlreichen Formen anpassen und anwenden können, um den Erfordernissen einer bestimmten Verwendung bestmöglich zu entsprechen.

### Verbesserung der Lebensdauer von CZ Si bei 280 °C

Wafer von 825 µm (durchschnittliche Lebensdauer) 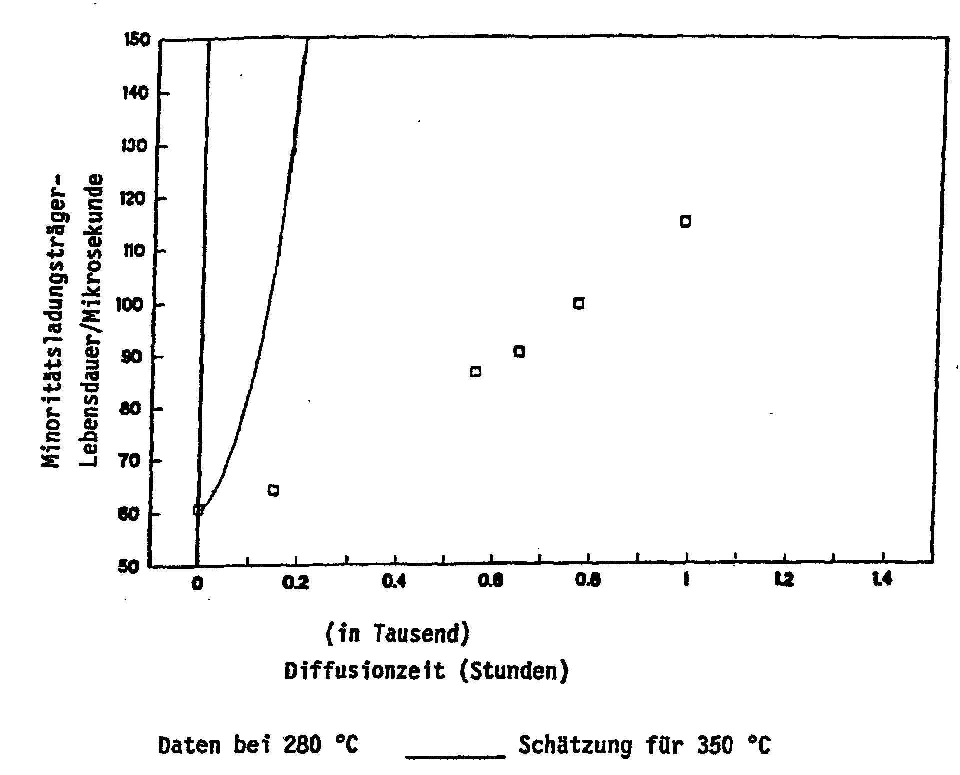
- Abb. 1: Lebensdauerverbesserungsdaten (Kästchen) für Silicium-Wafer mit einer Dicke von 625 Mikrometern, die bei 280 °C für eine längere Dauer gelagert wurden. Die Wafer hatten einen Durchmesser von 150 mm und p (100) eines spezifischen elektrischen Widerstands von 10 Ω-cm. Die durchgezogene Linie zeigt die geschätzte Verbesserung für eine Lagerung bei 350 °C.

### Verbesserung der Lebensdauer von MCZ Si bei 400 °C

Wafer mit einer Dicke von 1400 µm (durchschnittliche Lebensdauer) 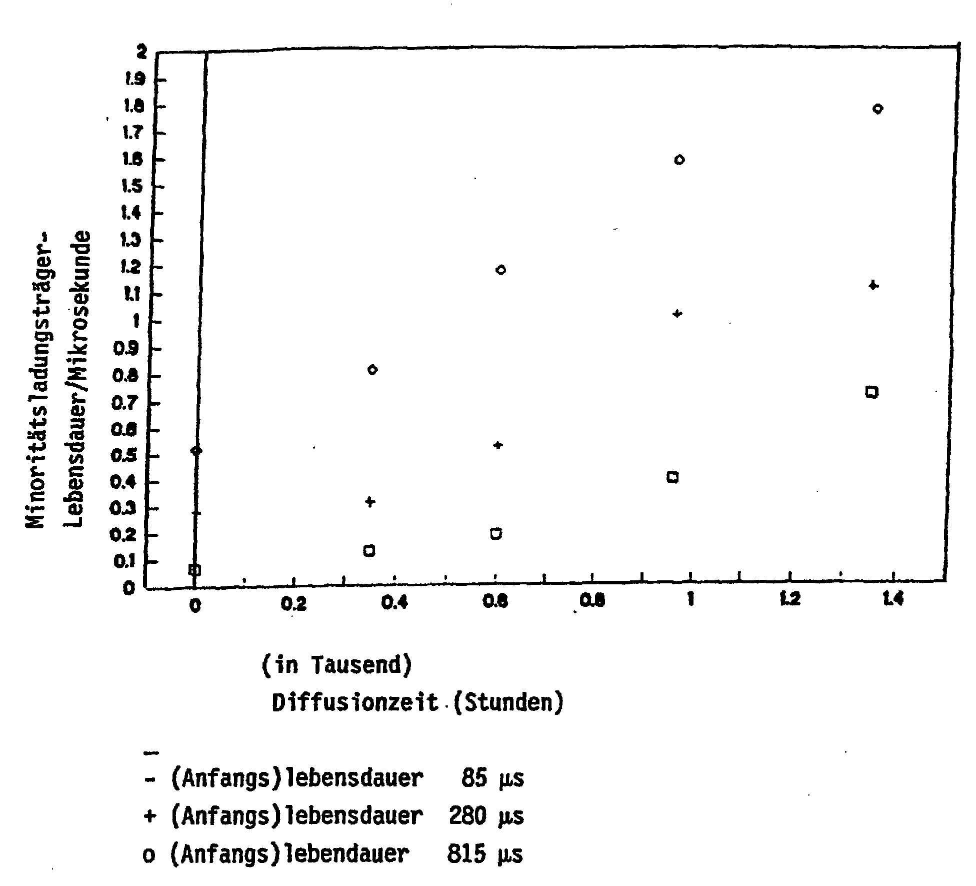
- Abb. 2: Lebensdauerverbesserungsdaten für Silicium-Wafer mit einer Dicke von 1400 Mikrometern mit verschiedenen durchschnittlichen Anfangslebensdauerwerten, die bei 400 °C für eine längere Zeit gelagert wurden. Die Wafer hatten einen Durchmesser von 150 mm und p(100) eines spezifischen elektrischen Widerstands von 5 Ω-cm.

## Patentansprüche

1. Ein Verfahren zur Erhöhung der Minoritätsladungsträger-Rekombinationslebensdauer in einem Siliciumkörper, der mit einem aus der aus Eisen, Chrom, Kobalt, Mangan, Zink und Vanadium bestehenden Gruppe ausgewählten Metall verunreinigt ist, wobei der Siliciumkörper bei einer ausreichenden Lagertemperatur und für eine ausreichende Lagerungsdauer gelagert wird, um eine Diffusion des Metalls aus dem Inneren des Siliciumkörpers an die Oberfläche des Siliciumkörpers zu bewirken wobei das Verfahren **dadurch gekennzeichnet ist, daß** die Lagerdauer mindestens 48 Stunden beträgt die Minoritätsladungsträger-Rekombinationslebensdauer des Siliciumkörpers meßbar zu erhöhen um.

2. Verfahren gemäß Anspruch 1, **dadurch gekennzeichnet, daß** der Siliciumkörper ein Bestandteil einer photovoltaischen Zelle ist.

3. Verfahren gemäß Anspruch 1, **dadurch gekennzeichnet, daß** der Siliciumkörper ein mit Eisen verunreinigter Silicium-Wafer ist und die Lagertemperatur nicht ausreichend ist, um sauerstoffbedingte Störstellen im Silicium zu erzeugen, jedoch mindestens 200°C beträgt, um eine Diffusion des Eisens aus Bereichen des Wafer-Inneren bei Abständen von der Waferoberfläche von mehr als 10% der Waferdicke, an die Oberfläche des Wafers zu bewirken, und das diffundierte Eisen von der Oberfläche des Wafers entfernt wird.

4. Verfahren nach Anspruch 3, wobei der Wafer bei einer ausreichenden Lagertemperatur und für eine ausreichende Dauer gelagert wird, um eine Diffusion des Eisens aus Bereichen des Waferinneren bei Abständen von der Waferoberfläche, die größer als 30% der Waferdicke sind, an die Oberfläche des Wafers zu bewirken.

5. Verfahren nach Anspruch 3, wobei das diffundierte Eisen von der Oberfläche des Wafers durch Polieren des Wafers entfernt wird.

6. Verfahren gemäß Anspruch 1, **dadurch gekennzeichnet, daß** der Siliciumkörper eine monokristalline Oberfläche aufweist.

7. Verfahren nach Anspruch 1, 2, 3 oder 6, wobei die Lagertemperatur zwischen 200°C und ca. 550°C liegt.

8. Verfahren nach Anspruch 1, 2, 3 oder 6, wobei die Minoritätsladungsträger-Rekombinationslebensdauer um mehr als etwa 200 Mikrosekunden erhöht wird.

9. Verfahren nach Anspruch 1, 2, 3 oder 6, wobei besagte Lagertemperatur etwa zwischen 250°C und 380°C liegt und besagte Lagerdauer mindestens ungefähr 96 Stunden beträgt.

10. Verfahren nach Anspruch 1, 2 oder 6, wobei der Siliciumkörper ein Siliciumwafer ist und das diffundierte Metall von der Oberfläche des Wafers durch Polieren des Wafers entfernt wird.

## Claims

1. A method for increasing the minority carrier recombination lifetime in a silicon body, which is contaminated with a metal selected from the group consisting of iron, chromium, cobalt, manganese, zinc and vanadium, wherein the silicon body is stored at a storage temperature and for a storage period sufficient to cause a diffusion of the metal from the interior of the silicon body to the surface of the silicon body, wherein the method is **characterized in that** the storage period is at least 48 hours, in order to measurably increase the minority carrier recombination lifetime of the silicon body.

2. The method according to claim 1, **characterized in that** the silicon body is a component of a photovoltaic cell.

3. The method according to claim 1, **characterized in that** the silicon body is a silicon wafer which is contaminated with iron, and the storage temperature is not sufficient to produce oxygen-induced defects within the silicon, but is at least 200°C, to cause a diffusion of the iron from regions in the interior of the wafer, at distances form the wafer surface of more than 10% of the thickness of the wafer, to the wafer surface, and the diffused iron is removed from the wafer surface.

4. The method according to claim 3, wherein the wafer is stored at a storage temperature and period sufficient to cause a diffusion of the iron from regions in the interior of the wafer, at distances from the wafer surface which are more than 30% of the thickness of the wafer, to the wafer surface,.

5. The method according to claim 3, wherein the diffused iron is removed from the wafer surface by polishing the wafer.

6. The method according to claim 1, **characterized in that** the silicon body has a mono-crystalline surface.

7. The method according to any one of claims 1, 2, 3 or 6, wherein the storage temperature is between 200°C and about 550°C.

8. The method according to any one of claims 1, 2, 3 or 6, wherein the minority carrier recombination lifetime is increased by more than about 200 microseconds.

9. The method according to any one of claims 1, 2, 3 or 6, wherein said storage temperature is between about 250°C and about 380°C and said storage period is at least about 96 hours.

10. The method according to any one of claims 1, 2 or 6, wherein the silicon body is a silicon wafer and the diffused metal is removed from the wafer surface by polishing the wafer.

## Revendications

1. Procédé pour augmenter la durée de vie de recombinaison des porteurs minoritaires dans un corps en silicium, qui est rendu impur avec un métal choisi parmi le groupe constitué du fer, du chrome, du cobalt, du manganèse, du zinc et du vanadium, le corps en silicium étant stocké à une température de stockage suffisante et pour une durée de stockage suffisante pour provoquer une diffusion du métal depuis l'intérieur du corps en silicium vers la surface du corps en silicium, le procédé étant **caractérisé en ce que** la durée de stockage atteint au moins 48 heures pour augmenter de façon mesurable la durée de vie de recombinaison des porteurs minoritaires du corps en silicium.

2. Procédé selon la revendication 1, **caractérisé en ce que** le corps en silicium est un composant de pile photovoltaïque.

3. Procédé selon la revendication 1, **caractérisé en ce que** le corps en silicium est une tranche de silicium rendue impure avec du fer et que la température de stockage n'est pas suffisante pour produire des cellules parasites dues à l'oxygène, qu'elle atteint cependant au moins 200°C pour provoquer une diffusion du fer depuis les zones du coeur de la tranche, à des distances de la surface de la tranche de plus de 10 % de l'épaisseur de la tranche, vers la surface de la tranche et **en ce que** le fer diffusé est éliminé de la surface de la tranche.

4. Procédé selon la revendication 3, dans lequel la tranche est stockée à une température de stockage suffisante et pour une durée de stockage suffisante pour provoquer une diffusion du fer depuis les zones du coeur de la tranche, à des distances de la surface de la tranche supérieures à 30 % de l'épaisseur de la tranche, vers la surface de la tranche.

5. Procédé selon la revendication 3, dans lequel le fer diffusé est éliminé de la surface de la tranche par polissage de la tranche.

6. Procédé selon la revendication 1, **caractérisé en ce que** le corps en silicium présente une surface monocristalline.

7. Procédé selon la revendication 1, 2, 3 ou 6, dans lequel la température de stockage se situe entre 200°C et environ 550°C.

8. Procédé selon la revendication 1, 2, 3 ou 6, dans lequel la durée de vie de recombinaison des porteurs minoritaires est augmentée de plus de 200 microsecondes environ.

9. Procédé selon la revendication 1, 2, 3 ou 6, dans lequel ladite température de stockage se situe environ entre 250°C et 380°C et ladite durée de stockage atteint au moins 96 heures environ.

10. Procédé selon la revendication 1, 2 ou 6, dans lequel le corps en silicium est une tranche de silicium et le métal diffusé est éliminé de la surface de la tranche par polissage de la tranche.
